# EUROPEAN PATENT APPLICATION

(11) **EP 4 841 506 A1**
(43) Date of publication of application: **18.11.2026**
(21) Application number: 25176732.3
(22) Date of filing: 15.05.2025
(51) Int. Cl.: G06N 3/045, G01D 21/00, G01R 31/3842, G06N 3/08

(54) **TECHNIQUE FOR TIME SERIES ESTIMATION WITH LONG-TERM EFFECT**

(71) Applicant: Robert Bosch GmbH, 70442 Stuttgart (DE)
(72) Inventor: Gerwinn, Sebastian, 71229 Leonberg (DE); Moshkovitz, Michal, Tel-Aviv (IL); Schiegg, Martin, 70825 Korntal-Muenchingen (DE); Di Castro, Dotan, 3440619 Haifa (IL)

(57) **Abstract**

A technique for providing, by a neural network, NN, system, an estimated time series of a physical parameter based on a time series of sensor data indicative of a long-term effect, comprises a method with a step of receiving input data comprising a time series of sensor data, determining (S106), for each point in time, if instantaneous sensor data are indicative of a predetermined long-term effect; selectively storing (S108) the instantaneous sensor data, for which an indication of the predetermined long-term effect was determined (S106); estimating (S110) a time series of a physical parameter based on the received (S102) input data, wherein the estimating (S110) comprises applying long-term effect attention to the selectively stored (S108) instantaneous sensor data for all points in time after the point in time, for which the instantaneous sensor data were selectively stored (S106); and providing (S112) the estimated (S110) time series as output data.

## Description

The present invention relates to a technique for providing an estimated time series of a physical parameter based on a time series of sensor data indicative of a long-term effect, in particular comprising a method, a neural network (NN) system, a further system comprising the NN system, and a computer program product.

### State of the Art

Machine learning (ML) models are often deployed in scenarios where specific events have a profound and lasting impact on predictions. Such traumatic events-occurrences that critically influence all subsequent predictions-are common across diverse applications. Traumatic data presents unique challenges, as models must not only recognize these events but also retain their impact over time to make accurate future predictions.

For instance, in battery technology, predicting the State of Health (SoH) is critical for ensuring performance and safety. An event like improper discharge can severely degrade a battery's health, and its consequences should be reflected in all subsequent SoH predictions. In healthcare, traumatic events like strokes or significant mental health episodes profoundly affect patients' health trajectories, necessitating models that can integrate these events into future health predictions. Similarly, in natural language processing (NLP), commands specifying tone or style (e.g., professional, or conversational) can influence the flow of interactions and should be accounted for in future predictions.

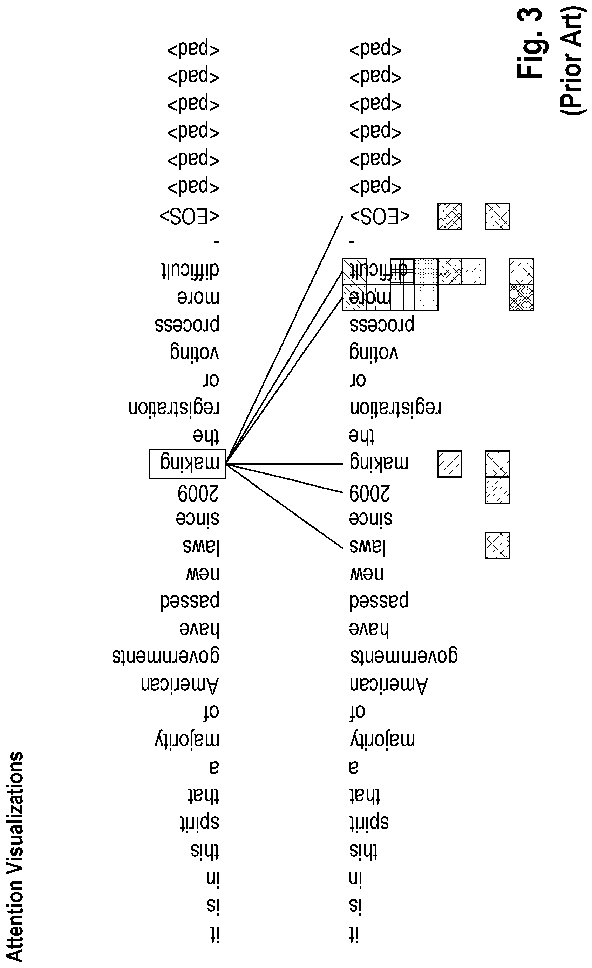

An attention mechanism for language processing was originally introduced in [1] and is the backbone of many foundation models. Fig. 3 from [1], which is reproduced as Fig. 3 of this application, schematically illustrates attention weights for the word "making". The conventional attention mechanism assigns high attention to words like "more" and "efficient".

The input to a ML model (e.g., a neural network, NN) with the attention mechanism is a time series *x*₁, *x*₂, ... ∈ *R^{d}*, where *d* is the embedding dimension. The output is another time series *r*₁, *r*₂, ... ∈ *R^{d}.*

In a first step, projections of the inputs are created, referred to as queries, keys, and values, for each input *i*: ${q}_{i} : = {x}_{i} {W}^{Q} \left[queries\right]$ ${k}_{i} : = {x}_{i} {W}^{K} \left[keys\right]$ ${v}_{i} : = {x}_{i} {W}^{V} \left[values\right]$

In a second step, attention weights for each query *qᵢ* are computed: ${w}_{i , j} = softmax \left({q}_{i}⋅{k}_{j}^{T}\right)$

In a third step, the conventional final result is returned by multiplying attention weights by the values: ${r}_{i} = {\sum }_{j} {w}_{i , j} {v}_{j} .$ (1)

Some events, like heart attacks and improper battery discharge, have profound and lasting effects, yet the ability of the conventional attention mechanism to handle such scenarios remains underexplored.

It is therefore an object of the present invention to provide a solution for improving a predictive power and/or time series estimation of some physical parameters in the presence of a long-term effect. Alternatively or in addition, it is an object to improve the interpretability of physical parameters derived from sensor data, in particular in time-like sequences.

### Disclosure of the Invention

This object is solved by a method for providing an estimated time series of a physical parameter based on a time series of sensor data indicative of a long-term effect, by a neural network (NN) system, by a further system comprising the NN system, and by a computer program (and/or computer program product), according to the appended independent claims. Advantageous aspects, features and embodiments are described in the dependent claims and in the following description together with advantages.

In the following, the invention will be described with respect to the claimed method first. Features, advantages or alternative embodiments, mentioned with respect to the method can be assigned to the other claimed objects (e.g. the computer program or a device, in particular the NN system, the further system, or a computer program product), and vice versa. In other words, the system, apparatus or device can be improved with features described or claimed in the context of the method, and vice versa. In this case, the functional features of the method are embodied by structural units of the apparatus or device or system and vice versa, respectively. The method may refer to a software implementation and the device, in particular the NN system, may refer to a hardware implementation (e.g. with a spatial physical structure) or a virtualization thereof. Generally, in computer science a software implementation and a corresponding hardware implementation (e.g. as an embedded system) are equivalent. Thus, for example, a method step for "storing" data may be performed with a storage unit and respective instructions to write data into the storage. For the sake of avoiding redundancy, although the device may also be used in the alternative embodiments described with reference to the method, these embodiments are not explicitly described again for the device. In principle, the respective device or apparatus claim is configured to carry out the claimed method.

As to a method aspect, a computer-implemented method for providing an estimated time series of a physical parameter based on a time series of sensor data indicative of a long-term effect is provided. The method is performed by a neural network (NN) system. The method comprises a step of receiving input data comprising a time series in at least a first channel of sensor data. The method further comprises a step of determining, for each point in time within the time series, if instantaneous sensor data associated with the point in time are indicative of a predetermined long-term effect. The method further comprises a step of selectively storing the instantaneous sensor data, for which an indication of the predetermined long-term effect was determined. The method further comprises a step of estimating a time series of at least one physical parameter based on the received input data. The estimating comprises applying (e.g., identical according to a rule or prescription) long-term effect attention to the selectively stored instantaneous sensor data for all points in time after the point in time, for which the instantaneous sensor data were selectively stored. The long-term effect attention may be applied additionally to any conventional short-term attention mechanism.

The method still further comprises a step of providing the estimated time series as output data.

By the technique disclosed herein, a predictive power of the at least one physical parameter (also: physical quantity) depending on the time series of sensor data can be improved. Alternatively or in addition, an interpretability of the prediction and/or estimate of the physical parameter can be increased. Further alternatively, modeling an evolution of the physical parameter based on the sensor data can be performed with increased accuracy.

The method is performed by a NN system, which receives a time series (also: sequence) as input data and provides another time series as output data. The time series of the input data and of the output data may be identical in terms of first point in time (also: start time) and/or last point in time (also: end time), in a number of points in time, and/or in a size of time steps. Alternatively, the time series of the output data may comprise a subset of the points in time of the time series of the input data.

The time series of the input data may comprise multiple channels, and/or may also be denoted as multivariate time series. The multivariate time series may be acquired by means of multiple sensors and/or by at least one multivariate sensor (e.g., comprising a first sensing unit to measure sensor data in a first channel, a second sensing unit to measure sensor data in a second channel, and so on, in particular simultaneously for all channels).

A multivariate time series may comprise a number of (in particular equally spaced) points in time (and/or time steps) with a predetermined start point in time and a predetermined end point in time. In one channel, sensor data acquired by means of a channel-specific sensor may be integrated (or comprised) for all points in time within the time series.

A channel of sensor data (e.g., the first channel or a second channel, and/or also denoted as input channel) may comprise (e.g., a time series) of one type of sensor data acquired by means of one sensor. The sensor data within a (e.g., the first or second) channel may alternatively be denoted as (in particular direct) measurement data. The measurement data may be indicative of a physical state (such as an electrical state and/or a mechanical state) per point in time and/or may be measured in physical units, in particular one kind of physical unit per channel, and preferably a different physical unit for a different channel. E.g., the first channel of sensor data may comprise voltage values, which may also be denoted as indication of voltage.

Alternatively or in addition, the second channel of sensor data may comprise current values, which may also be denoted as indication of current.

The input data may comprise a time series of physical values, like e.g., voltage values and a time series of current values, taken at identical points in time for the two channels of the time series.

By the time series comprising multiple channels, complementary sensor data may be acquired. E.g., a multivariate sensor may provide voltage and current in two different channels. Alternatively or in addition, a multivariate sensor may for example provide volume flow and mass flow in two different channels.

By the acquisition of the complementary sensor data, an accuracy of monitoring (and/or predicting) a status of a physical object (and/or device) monitored by the multivariate sensor and/or the multiple sensors (e.g., a state of health, SoH, of a battery) and/or of natural state (e.g., an environment, weather, and/or territorial data, e.g., regarding a likelihood of a natural event, such as an earth quake) can be improved.

The output data may comprise a time series in at least one channel. Alternatively or in addition, the output data may provide a time series of one physical parameter per output channel.

In some examples, the physical parameter in an output channel may be of the same type as the sensor data in an input channel. Alternatively or in addition, in other examples, the physical parameter in at least one output channel may be of different type from any one of the sensor data in the input channels.

The output data may be indicative of the (e.g., monitored and/or predicted) status of the physical object (and/or device) or the natural state. Alternatively or in addition, the output data may correspond to virtual sensor data and/or indirect measurement data. The virtual sensor data and/or indirect measurement data may be derived from the input data. The derived measurement data (and/or virtual sensor data) may be indicative of the status of the physical object and/or may be measured in a physical unit in case of one output channel (and several different physical units in case of multiple output channels).

In an example embodiment, the physical parameter may comprise a state of health (SoH) of a rechargeable battery or a capacitor, and the sensor data may comprise voltage and/or current. Alternatively or in addition, the sensor data may comprise capacity, inner resistance, temperature, and/or charging cycles. For a capacitor, the sensor data may, e.g., in addition comprise leakage current, series resistance, and/or insulation resistance.

Other examples refer to the SoH of other physical components. In this case, that sensor data may comprise, for instance, time, temperature, and/or other physical parameters for predicting the SoH of the very technical component.

Instantaneous sensor data indicative of a (in particular predetermined) long-term effect, briefly also: a long-term effect event (also: anomaly, traumatic event, and/or adverse event), may be sensor data (and/or an event) at a specific point within a time series, which is crucial for accurately predicting all future outcomes. E.g., a long-term effect event may be an unusual and/or non-standard event, such as a sudden (and/or abrupt) discharge of a rechargeable battery. Instantaneous sensor data may be construed as data having profound and lasting impact on subsequent predictions or critically influencing the same.

Alternatively or in addition, instantaneous sensor data being indicative of a long-term effect may comprise a difference between the sensor data at one point in time and the sensor data at a (e.g., directly) preceding point in time exceeding a predetermined threshold. Further alternatively or in addition, instantaneous sensor data being indicative of a long-term effect may comprise the sensor data at one point in time deviating from expected sensor data, in particular by an amount larger than a predetermined threshold.

The predetermined threshold may in any case be a numerical threshold related to the channel, in which the sensor data are received. E.g., for a voltage the numerical value may be a value in Volt (V), and/or for an electrical current the numerical value may be a value in Ampere (A).

In some examples, the long-term effect may negatively impact a performance, and/or a lifetime of a physical object. In other examples, the long-term effect may positively impact the performance and/or lifetime of the physical object.

In some examples, the long-term effect (e.g., a nuclear incident, an earthquake, a tornado or another natural event) may negatively impact a natural state. In other examples, the long-term effect may positively impact the natural state.

The long-term effect may relate to a long-term effect on future predictions.

A long-term prediction of the performance of a battery may be characterized by a battery state. The battery state may comprise a State of Charge (SoC), and/or a State of Health (SoH). The SoC may describe a difference between a fully charged battery and the same battery in use, and/or may be associated with a remaining quantity of electricity available in the battery. The SoC may be defined as the ratio of remaining charge of the battery divided by the maximum charge that can be delivered. The SoC may in particular be expressed as percentage. The SoC may alternatively be expressed as Depth of Discharge (DoD), which may correspond to the difference of 100% and the SoC in percent.

The SoH may describe a difference between a battery in use and a fresh batter, and/or may consider degradation, and/or aging, over the lifetime of a battery. The SoH may be defined as the ratio of a maximum battery charge to its rated capacity. Alternatively or in addition, the SoH may be expressed as a percentage.

A discharge profile of a rechargeable battery may depend, and/or may be related to its SoH. In particular, the lower the SoH, the faster the battery may be discharged.

A predetermined long-term effect of a rechargeable battery may comprise an abrupt change (in particular an abrupt drop) in in a current and/or voltage provided by the battery.

The SoC may be derived from a time series of the charge of the battery, and/or from a measurement of current and time. Alternatively or in addition, the SoH may be determined based on, or may be related to, the quantity of charge that can be stored by the battery (in particular at a specific time).

The capacity of a new battery may be identical to a nominal capacity. The SoH for a new battery may be 100%.

The capacity of a battery in use may decrease over time and/or over usage (e.g., comprising a number of charging cycles, and/or a number of at least partial re-chargings).

A poor SoH may lead to unstable and/or unreliable performance.

The SoH of a battery may be important for electric vehicles, hybrid vehicles, and/or robotics. In the following, explicit reference is made to vehicle batteries. For robots equipped with rechargeable batteries, analogous statements apply. Robots (in particular mobile robots powered by a rechargeable battery) may, e.g., be deployed in a factory environment, in a home automation environment, and/or a facility, such as a medical facility.

Unstable and/or unreliable performance of a vehicle battery may be a safety risk, such as the vehicle suddenly stopping and/or having partially non-working functionalities (e.g., outage of power-assisted steering, also: servo-steering mechanism, of electronic brakeforce distribution, EBD, of electronic stability control, ESC, of lights, of sensors, and/or of autonomous driving functions).

Autonomous driving may comprise any one of the Level 1 (driver assistance), Level 2 (partial automation), Level 3 (conditional automation), Level 4 (high automation), and/or Level 5 (full automation) according to the Society of Automotive Engineers classification system.

Alternatively or in addition, based on a current SoH of a battery, an estimate of the battery's lifetime may be performed, and/or a date for changing the battery may be scheduled.

The SoH of a battery may be (e.g., conventionally) derived from an internal resistance (and/or impedance and/or conductance), from a capacity, from a voltage, from a self-discharge, from an ability to accept a charge, from a number of charge-discharge cycles, from an age of the battery, from a temperature of the battery during its previous uses, and/or from a total energy charged and discharged.

According to the technique disclosed herein, the SoH may be determined by a trained neural network (NN) system based on sensor data related to the vehicle battery, such as voltage and current.

The trained NN system may comprise an encoder-decoder pair, a recurrent neural network (RNN), a convolutional neural network (CNN), and/or a transformer architecture. The trained NN system may alternatively or in addition comprise a plurality of layers, in particular self-attention layers, multilayer perceptron (MLP) layers, and/or residual connections.

The attention to the selectively stored instantaneous sensor data indicative of a long-term effect may be implemented in addition to a conventional attention mechanism. The conventional attention mechanism may assign attention weights to all instantaneous sensor data within the time series. Alternatively or in addition, the conventional attention mechanism may take instantaneous sensor data into account only for a small number (and/or a subset) of the points in time after the instantaneous sensor data were acquired. Further alternatively or in addition, the conventional attention mechanism may (e.g., only) take into account short-term effects.

The NN system may be trained by supervised training, and/or using training data comprising a ground truth. E.g., in the case of SoH as output data, a ground truth SoH may have been provided manually, and/or according to a specific formula (which may differ across a database of training datasets), in association with the sensor data.

A long-term effect event for the SoH of a vehicle battery may comprise an instantaneous drop of voltage and/or current.

Battery degradation for a vehicle battery may be due to a driving pattern, such as aggressive driving (e.g., comprising breaking and/or accelerating), climate, thermal dynamics in relation to the battery environment and/or the battery usage, and/or infrastructure. Any one of these causes for battery degradation may produce, or correspond to, a long-term effect event.

The method may be performed by a NN system deployed within a battery management system.

In the health sector, a long-term effect event may comprise a stroke, a heart attack, a transient ischemic attack (TIA), and/or a (e.g., epileptic) seizure.

In natural language processing (NLP), a command relating to a diction, such as light, academic, and/or professional.

Determining if the instantaneous sensor data are indicative of a long-term effect may comprise assigning (e.g., conventional) weights to all instantaneous sensor data and subsequently applying a predetermined (in particular lower) threshold value of the weights. E.g., all instantaneous sensor data with a weight above a predetermined threshold value may be considered to be indicative of a long-term effect. The thresholding may also be denoted as binary classification or ranking the top elements (and/or top instantaneous sensor data).

Alternatively or in addition, determining if the instantaneous sensor data are indicative of a long-term effect may comprise ranking the instantaneous sensor data.

The (e.g., conventional) weights and/or rankings may be learned during the training of the NN system.

The instantaneous sensor data, which are determined to be indicative of a long-term effect, may be routed, in particular by a router, to a long-term effect memory for the selective storing.

The estimate of the time series of the physical parameter may comprise combining the conventional attention mechanism with the long-term effect-specific attention mechanism. The combination may comprise that, for all sensor data, conventional weights are applied.

The conventional attention mechanism may in particular comprise determining, for each of the instantaneous sensor data, key, value, and query. Determining key, value and query may make use of parameters learned during the training of the NN system.

The weights of the conventional attention mechanism may be determined based on a SoftMax operation of a production of a query and a key for all possible combinations of instantaneous sensor data.

The time series in various channels of sensor data may, according to the technique disclosed herein, comprise both time-dimension dependency and cross-dimension dependency. The cross-dimension dependency may refer to the dependency between different channels of sensor data, and/or between different types of sensor data, such as voltage and current.

The long-term effect-specific attention mechanism may comprise determining an additional contribution (e.g., an additional term to be summed with the output of the conventional attention mechanism) from the instantaneous sensor data indicative of the long-term effect to the output data after the point in time, at which the long-term effect event occurred.

The long-term effect-specific attention mechanism may differ from a conventional mixture-of-depth (MoD) technique, which restricts portions of the input data to be processed by an attention mechanism, and where the remaining portions of the input data bypass the attention mechanism entirely. Conventionally, the MoD technique may be used to reduce computational requirements.

The long-term effect-specific attention mechanism disclosed herein differs from the conventional MoD in several ways. In particular, the technique disclosed herein is designed to assist in preserving long-term effect memories (also: traumatic memories). The disclosed technique for this only uses the concept of "sorting out" sensor data, which do not take part in the long-term effect, versus storing the sensor data with long-term effect in a dedicated long-term effect memory. Said differently, the disclosed technique utilizes ideas from the conventional MoD as a component of a different system focused on preserving specific data (traumatic memories) in memory.

The technique disclosed herein differs from the conventional MoD in the implementation, such as by employing a specific score function for the router and using distinct attention values for tokens stored in the long-term effect memory.

A channel, in particular the first channel, of sensor data may comprise sensor data indicative of a voltage, a current, a power, a resistance, a capacity, a temperature, a humidity, a gas concentration, a pressure, a velocity, a force, a torque, a rotational speed, a color, and/or a luminosity.

The sensor data may be related to a physical state, in particular a physical state of an object such as a rechargeable battery. The estimate of the physical parameter of the object may be based on the sensor data acquired in relation to the object, and/or may be indicative of a physical state of the object.

In some examples, the sensor data and the estimated physical parameter may be of the same type (e.g., a modified color when comparing output data with input data). In other examples, the physical parameter may be a derived (and/or in particular not directly by a sensor acquirable) type of data, such as the SoH of a rechargeable battery.

The sensor data may be acquired by means of at least one sensor. In case of multiple channels of sensor data, a (e.g., multivariate) sensor may comprise multiple sub-units, and/or a set of sensors may be synchronized for acquiring sensor data at identical points in time.

The method may further comprise a step of routing the instantaneous sensor data, for which the indication of the predetermined long-term effect was determined to a long-term effect memory.

The routing may be performed by a router of the NN system. Alternatively or in addition, the routing may comprise copying the selected instantaneous sensor data indicative of the long-term effect, and storing the copy in the long-term effect memory, in particular while exposing the selected instantaneous sensor data also to the same processing as the non-selected instantaneous sensor data.

The NN system may comprise an encoder and a decoder. Alternatively or in addition, the NN system may comprises a transformer architecture, a RNN architecture, and/or a CNN architecture.

The NN system may comprise at least one (e.g., conventional) attention layer within the encoder and/or within the decoder. Alternatively or in addition, the long-term effect attention mechanism may be implemented in the encoder, in the decoder, or in both.

The long-term effect attention may comprise that, for any point in time after the long-time effect in the in the sensor data was determined, the estimate of the at least one physical parameter depends on the sensor data indicative of the long-term effect. E.g., all later sensor data may be modified according to an identical procedure (also: prescription), and/or the long-term effect may comprise that the long-term attention does not fade with time.

In one example, all values of a physical parameter after the long-term effect may comprise an offset compared to the values of the physical parameter before the long-term effect. E.g., a SoH of a rechargeable battery may be (e.g., abruptly) lowered or decreased by a predetermined offset at the point in time, at which the long-term effect occurs, and for all later points in time, the same predetermined offset may be applied. Alternatively or in addition, all values of a physical parameter after the long-term effect may comprise a multiplicative factor compared to the values of the physical parameter before the long-term effect. E.g., RGB color values may be reduced by a multiplicative factor, resulting in darker shades after the point in time of the long-term effect.

The inventive long-term effect attention may be combined with conventional short-term attention mechanisms.

The time series comprised in the received input data may comprise a second channel of sensor data. Optionally, the first channel may comprise sensor data indicative of a voltage of a rechargeable battery. The second channel may comprise sensor data indicative of a current of the rechargeable battery.

The sensor data within the different channels may be complementary, and/or may provide complementary information regarding the evolution of a physical state.

The sensor data may be indicative of a physical state of a physical object. The time series of the at least one physical parameter may encode the physical state of the physical object.

The at least one physical parameter may comprise a state of health (SoH) of a rechargeable battery.

In an alternative example, the sensor data may be associated with a (e.g., local) environment, and/or a (e.g., local) climate. The physical parameter may, e.g., be indicative of weather. A long-term effect may, e.g., be due to a hurricane or another extreme weather event.

Alternatively or in addition, the sensor data may be able to capture an indication of an environmental or natural catastrophe, such as a wildfire, a land slide, or an earthquake. The physical parameter may be indicative of a state of the environment, such as under normal circumstances and/or after the environmental or natural catastrophe.

Still further examples of sensor data may comprise sensor data indicative of a traffic situation, e.g., an empty road, a traffic congestion, and/or an accident as a further example of a long-term effect event. The physical parameter may, e.g., comprise a prognosis on the development of the traffic situation.

The method may further comprise a step of preprocessing the received input data. Preprocessing may comprise providing a positional encoding for each of the instantaneous sensor data.

Positional encoding of the each of the instantaneous sensor data may comprise assigning a time stamp (in particular in relation to a point in time within the time series) and/or a channel to the instantaneous sensor data.

In one example, raw sensor data (e.g., separately for each channel) are received and then preprocessed. By the preprocessing, the sensor data may be converted into a data format suitable for processing by the NN system. Alternatively or in addition, by the preprocessing, a positional encoding, such as comprising the point in time within the time series (and/or the channel), may be provided. Positional encoding is typically used in case of using a transformer architecture to inject information about the order of tokens in a sequence since transformers lack built-in sequence awareness, for instance by using a sinusoidal positional encoding. Herein, a token may denote instantaneous sensor data within one channel and/or at one point in time.

In another example, the input data are received as preprocessed data, e.g., already converted to a data format suitable for processing by the NN system, and/or already comprising positional encodings.

The method may further comprise a step of determining, for each point in time within the time series, attention weights associated with the instantaneous sensor data. Determining if the instantaneous sensor data are indicative of a predetermined long-term effect may comprise determining that the associated attention weight exceeds a predetermined threshold value.

Estimating the time series of at least one physical parameter may alternatively or in addition comprise applying the determined attention weights to all instantaneous sensor data, in particular including the instantaneous sensor data indicative of a predetermined long-term effect.

The technique disclosed herein may in particular combine the conventional attention mechanism for all sensor data, and/or all points in time, with the long-term effect attention mechanism for the selected sensor data indicative of the long-term effect. Thereby, (e.g., short-term) attention may be used for any sensor data, and attention to long-term effect sensor data may be increased, and/or applied longer into the future after the long-term effect event. In particular, the attention to long-term effect sensor data may be applied from its occurrence up to the end of the time series.

In some examples, the time series need not have a predetermined end. E.g., the time series may be started by activating a sensor, and/or a sensor may remain activated until the end of its own lifetime, until the end of the lifetime of a physical object it senses, and/or until a maintenance event (or any other, in particular manual, stop event) occurs.

Applying long-term effect attention may comprise applying a predetermined projection matrix on a linear function of the instantaneous sensor data indicative of a predetermined long-term effect. Alternatively or in addition, applying long-term effect attention may comprise applying a non-linear function on the instantaneous sensor data indicative of a predetermined long-term effect.

The predetermined projection matrix may be applied to the value (in particular among the quantities key, value, and query) associated with the instantaneous sensor data indicative of a predetermined long-term effect.

The NN system may be trained by means of supervised learning on a database of training datasets comprising a time series in at least a first channel of sensor data and a time series of at least one physical parameter as ground truth.

By the supervised learning, the attention weights for the conventional attention mechanism as well as applying the long-term effect attention, in particular in terms of a projection matrix, may be learned.

The training may be performed on a larger computing device, on a computing cluster, and/or in a computing cloud. Alternatively or in addition, the trained NN system may be deployed on a computing device with limited processing and/or memory resources, such as in a battery management system within a vehicle.

The supervised training may make use of optimizing a loss function, such as minimizing a mean squared error (MSE).

The instantaneous sensor data, for which an indication of the predetermined long-term effect was determined, may be selectively stored in a long-term effect memory. A size of the long-term effect memory may be parameterized by a tunable hyperparameter.

If only one type of long-term effect event is known, the tunable hyperparameter may in particular be set to 1.

The tunable hyperparameter may be selected by means of a user input, e.g., before training the NN system.

As to a device aspect, a NN system for providing an estimated time series of a physical parameter based on a time series of sensor data indicative of a long-term effect is provided. The NN system comprises an input layer, which is configured for receiving input data comprising a time series in at least a first channel of sensor data. The NN system further comprises a first set of hidden layers, which is configured for determining, for each point in time within the time series, if instantaneous sensor data associated with the point in time are indicative of a predetermined long-term effect. The NN system further comprises a long-term effect memory, which is configured for selectively storing the instantaneous sensor data, for which an indication of the predetermined long-term effect was determined. The NN system further comprises a second set of hidden layers, which is configured for estimating a time series of at least one physical parameter based on the received input data. The estimating comprises applying long-term effect attention to the selectively stored instantaneous sensor data for all points in time after the point in time, for which the instantaneous sensor data were selectively stored. The NN system still further comprises an output layer, which is configured for providing the estimated time series as output data.

The NN system may further comprise any one of the features, or may be configured to perform any one of the steps, disclosed in the context of the method aspect.

A further system may comprise the NN system and at least one sensor, by means of which the input data are acquired. Optionally, the further system may further comprise a user interface (UI), such as a graphical user interface (GUI), on which the output data may be displayed.

As to a further aspect, a computer program product is provided comprising program elements which induce a computing device (e.g., embodying the NN system) to carry out the steps of the method for providing an estimated time series of a physical parameter based on a time series of sensor data indicative of a long-term effect according to the method aspect, when the program elements are loaded into a memory of the computing device.

As to a still further aspect, a computer-readable storage medium is provided on which program elements are stored that can be read and executed by a computing device (e.g., embodying the NN system), in order to perform steps of the method for providing an estimated time series of a physical parameter based on a time series of sensor data indicative of a long-term effect according to the method aspect, when the program elements are executed by the computing device.

The properties, features and advantages of this invention described above, as well as the manner they are achieved, become clearer and more understandable in the light of the following description and embodiments, which will be described in more detail in the context of the drawings.

This following description does not limit the invention on the contained embodiments. Same components or parts can be labeled with the same reference signs in different figures. In general, the figures are not for scale.

It shall be understood that a preferred embodiment of the present invention can also be any combination of the dependent claims or above embodiments with the respective independent claim.

These and other aspects of the invention will be apparent from and elucidated with reference to the embodiments described hereinafter.

### Brief description of the drawings

Fig. 1 is a flow chart of an exemplary method for providing an estimated time series of a physical parameter based on a time series of sensor data indicative of a long-term effect.
Fig. 2 is an overview of the structure and architecture of a NN system for providing an estimated time series of a physical parameter based on a time series of sensor data indicative of a long-term effect. The NN system may be configured to perform the method of Fig. 1.
Fig. 3 shows an example of a conventional short-term attention mechanism applied to language processing.
Fig. 4 schematically illustrates a first example of a long-term effect, in which input data and output data are of the same type, in particular colors or patterns of a patch per point in time, in which a black patch is identified as long-term effect, by which all future outputs are modified.
Fig. 5 shows an example of voltage and current as two channels of a time series of sensor data of a rechargeable battery, and a state of health (SoH) as estimated time series of the battery's physical parameter.
Fig. 6 schematically illustrates a limitation of the conventional attention mechanism in the presence of a long-term effect in addition to regular, short-term effect, sensor data.
Fig. 7 schematically illustrates the conventional method-of-depth (MoD) technique, with the inventive long-term effect attention being interpretable as modification thereof.
Figs. 8A and 8B schematically illustrate the time series estimating of a physical parameter, if the instantaneous sensor data are indicative of a long-term effect and if the instantaneous sensor data are not indicative of the long-term effect, but previous sensor data were indicative of the long-term effect, respectively.
Fig. 9 schematically illustrates pseudocode and NN system architecture components for performing the method of Fig. 1.
Figs. 10A and 10B schematically illustrate the improvement using the inventive long-term effect attention disclosed herein as compared to only the conventional mechanism for the color or pattern example of Fig. 4.
Figs. 11A, 11B and 11C exemplarily show further time series with colors or patterns as inputs per row, extending the example of Fig. 4, with Fig. 11A showing the input data, Fig. 11B showing the ground truth, and Fig. 11C showing the estimate obtained by a NN system, such as the NN system of Fig. 2.

### Detailed description

Any reference signs in the claims should not be construed as limiting the scope.

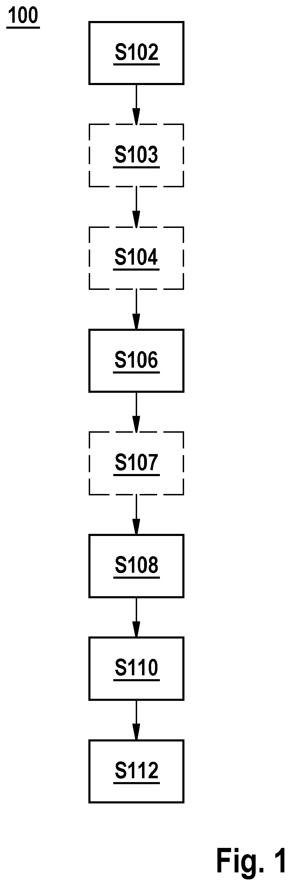

Fig. 1 schematically illustrates an exemplary flowchart for a (in particular computer-implemented) method 100 for providing, by a neural network (NN) system, an estimated time series of a physical parameter based on a time series of sensor data indicative of a long-term effect.

The method 100 comprises a step S102 of receiving input data comprising a time series in at least a first channel of sensor data. The method 100 further comprises a step S106 of determining, for each point in time within the time series, if instantaneous sensor data associated with the point in time are indicative of a predetermined long-term effect. The method 100 further comprises a step S108 of selectively storing the instantaneous sensor data, for which an indication of the predetermined long-term effect was determined S106. The method 100 further comprises a step S110 of estimating a time series of at least one physical parameter based on the received S102 input data. The estimating S110 comprises applying long-term effect attention to the selectively stored S108 instantaneous sensor data for all points in time after the point in time, for which the instantaneous sensor data were selectively stored S106. The method 100 still further comprises a step S112 of providing the estimated S110 time series as output data.

Optionally, the method 100 comprises a step S103 of preprocessing the received S102 input data. Preprocessing S103 may comprise providing a positional encoding for each of the instantaneous sensor data.

The method 100 may comprise a step S104 of determining, for each point in time within the time series, attention weights associated with the instantaneous sensor data. Determining S106 if the instantaneous sensor data are indicative of a predetermined long-term effect may comprise determining that the associated attention weight exceeds a predetermined threshold value. Estimating S110 the time series of at least one physical parameter may further comprise applying the determined S104 attention weights to all instantaneous sensor data, in particular including the instantaneous sensor data indicative of a predetermined long-term effect.

The method 100 may comprise a step S107 of routing the instantaneous sensor data, for which the indication of the predetermined long-term effect was determined S104, to a long-term effect memory.

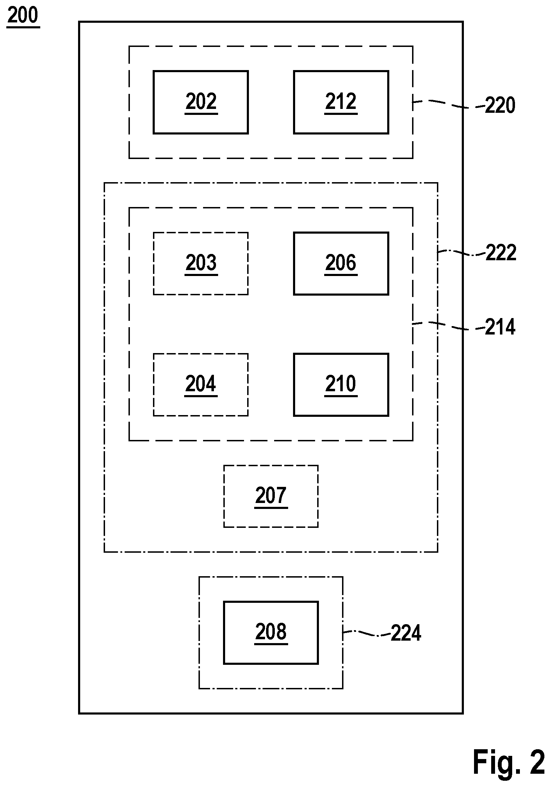

Fig. 2 schematically illustrates an exemplary architecture of an NN system 200 for providing an estimated time series of a physical parameter based on a time series of sensor data indicative of a long-term effect.

The NN system 200 comprises an input layer 202, which is configured for receiving input data comprising a time series in at least a first channel of sensor data. The NN system 200 further comprises a first set of hidden layers 206, which is configured for determining, for each point in time within the time series, if instantaneous sensor data associated with the point in time are indicative of a predetermined long-term effect. The NN system 200 further comprises a long-term effect memory 208, which is configured for selectively storing the instantaneous sensor data, for which an indication of the predetermined long-term effect was determined. The NN system 200 further comprises a second set of hidden layers 210, which is configured for estimating a time series of at least one physical parameter based on the received input data. The estimating comprises applying long-term effect attention to the selectively stored instantaneous sensor data for all points in time after the point in time, for which the instantaneous sensor data were selectively stored. The NN system 200 still further comprises an output layer 212, which is configured for providing the estimated time series as output data.

Optionally, the NN system 200 comprises a third set of hidden layers 203, which is configured for preprocessing the received input data. Preprocessing comprises providing a positional encoding for each of the instantaneous sensor data.

The NN system 200 may comprise a fourth set of hidden layers 204, which is configured for determining, for each point in time within the time series, attention weights associated with the instantaneous sensor data. Determining if the instantaneous sensor data are indicative of a predetermined long-term effect may comprise determining that the associated attention weight exceeds a predetermined threshold value. Estimating the time series of at least one physical parameter may further comprise applying the determined attention weights to all instantaneous sensor data, in particular including the instantaneous sensor data indicative of a predetermined long-term effect.

The NN system 200 may comprise a router 207, which is configured for routing the instantaneous sensor data, for which the indication of the predetermined long-term effect was determined, to the long-term effect memory 208.

The NN system 200 may be configured for performing the method 100.

The NN system 200 may be embodied by a computing device. The computing device may comprise an input-output interface 220, a processor 222, and memory 224. The input-output interface 220 may embody the input layer 202 and the output layer 212. Alternatively or in addition, the processor 222 may embody any one of the hidden layers 214 (e.g., the first set of hidden layers 206, the second set of hidden layers 210, the third set of hidden layers 203, and/or the fourth set of hidden layers 204) and/or the router 207.

The memory 224 may embody the long-term effect memory 208.

A further system may comprise the NN system 200 and sensors, by which time series in one or more channels of sensor data can be acquired. Alternatively or in addition, the further system may comprise a UI, such as a GUI, for displaying the output of the estimated time series of the time series of the at least one physical parameter.

The system may be configured to perform the method 100.

The technique disclosed herein (e.g., comprising the method 100, and/or the computing device 200) may also be denoted as solution to a Traumatic Test, and/or as novel benchmark designed to abstract the challenge of improved time series prediction. Both empirical and theoretical evidence is provided that conventional self-attention layers struggle with the test. To overcome these limitations, the disclosed technique uses a new Traumatic Memory mechanism, leveraging the conventional mixture-of-depths technique to effectively capture long-lasting effects. Empirical results demonstrate that this technique enables attention layers to successfully pass the Traumatic Test, showcasing its potential to improve model performance in scenarios with persistent impacts.

To evaluate the ability of the technique disclosed herein to process scenarios with persistent impacts, the Traumatic Test is proposed, an abstraction of the problem that tests whether a model (e.g., a NN system) can effectively handle traumatic data. Using the disclosed technique, it is shown both experimentally and theoretically that existing attention mechanisms are not well-suited for such tasks. Intuitively, the problem arises because the conventional self-attention mechanism imposes constraints on how vectors relate to one another. Specifically, the conventional mechanism enforces that certain vectors should simultaneously be close and far from each other, creating conflicts.

In experiments, a single-layer attention mechanism has been evaluated by comparing it to the prediction identity function, and it has been demonstrated that its performance deteriorates significantly when processing a long-term effect event (also: traumatic data). Theoretically, it can be shown that, for normalized keys and queries, it is impossible to achieve the desired attention patterns. This can be proven using the triangle inequality of norms and Cauchy-Schwarz inequality. These results highlight the limitations of conventional (e.g., network) architectures and motivate the need for alternative approaches.

To address the limitations of self-attention in handling traumatic data, according to the technique disclosed herein, a novel architecture augments the self-attention mechanism with a long-term effect memory (also: traumatic memory) component. This traumatic memory explicitly saves the long-term effect events (also: traumatic events) themselves, ensuring they are always retained and accessible throughout the estimation (and/or prediction) process. By explicitly storing these critical events, the traumatic memory alleviates the burden on the attention mechanism, which no longer needs to focus on these events repeatedly at every computation step. This directly resolves the conventional conflicting constraints on vector relationships that have been identified as a key issue with traditional self-attention mechanisms.

The content of the long-term effect memory (and/or traumatic memory) is determined dynamically using a modification of a mixture-of-depth technique, which identifies and stores the most pivotal events (and/or the long-term effect events) in the sequence (and/or time series). This design ensures that the long-term effect memory reliably captures the long-term effect events (also: critical events) without requiring the attention mechanism to repeatedly highlight them. Furthermore, because the long-term effect memory explicitly stores the long-term effect events (and/or critical events) that influence predictions, it introduces an important degree of interpretability. Practitioners can directly examine the long-term effect memory contents to understand which events the model (and/or the NN system) considers critical, a particularly valuable feature in domains where trust and transparency are essential.

By integrating long-term effect (and/or traumatic) memory with self-attention, the disclosed technique, in particular comprising a NN system architecture, overcomes the inherent limitations of conventional self-attention in processing long-term effect data (and/or traumatic data). A key improvement lies in how the long-term effect memory complements attention: the long-term effect memory ensures that long-term effect events (and/or pivotal events) are persistently accessible and their influence retained, allowing the attention mechanism to focus on other aspects of the sequence (and/or time series). This separation of responsibilities not only resolves the conflicting constraints of conventional self-attention but also streamlines the NN system's (and/or model's) computation by removing the need to repeatedly attend to the long-term effect events (and/or traumatic events).

Prior to the technique disclosed herein, to the best inventors' knowledge, no neural networks (NN) had been studied specifically to handle long-term effect data (and/or "traumatic" data), despite their occurrence in various types of time series data.

Data may be defined as having a long-term effect (also: being traumatic) when an event is crucial for accurately predicting all future outcomes. For instance, in the context of batteries, the objective is to predict the State of Health (SoH) of the batteries. If a battery is discharged improperly, it can significantly affect its SoH over the long term. Alternatively or in addition, in the health sector, a stroke is an event that can have lasting repercussions on a patient's condition when predicting their health status. Further alternatively or in addition, in natural language processing (NLP), certain commands can influence all subsequent conversations. For example, if one wants the response to be of a specific type-such as light, academic, or professional-these commands can have a lasting impact.

The technique disclosed herein introduces a novel NN system architecture, such as a novel transformer architecture, specifically designed for long-term effect data (also: traumatic data). A new task that highlights the unique characteristics of traumatic data is introduced, and the limitations of conventional transformers when applied to traumatic data are discussed. The disclosed technique comprises an innovative architecture specifically tailored for effectively handling traumatic data. Empirical comparisons are conducted between the original attention mechanism and the novel architecture on an exemplary new task, demonstrating improvements ranging from a factor of 5 to 100 on certain datasets.

A primary advantage of the technique disclosed herein is its improved predictive power. A secondary benefit is the increased interpretability of the NN system architecture. This is achieved through the introduction of a new component that identifies and highlights specific coordinates with significant global influence, offering additional insights without compromising the NN system's (also: model's) primary objective of predictive performance.

Another advantage of the disclosed technique is the ability to identify a difficulty present in conventional transformers when dealing with traumatic data. This insight provides an understanding of how to design a new attention mechanism better suited for such data. This challenge is illustrated by introducing a new task.

Long-term effect attention may be imposed as performing a "traumatic task".

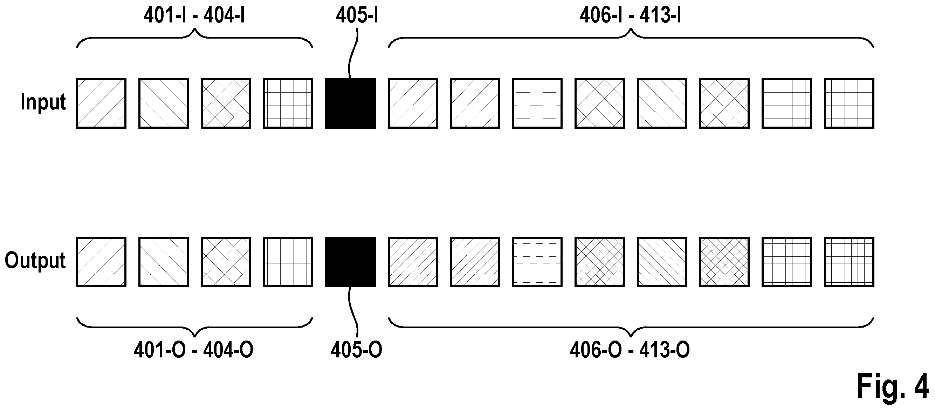

Fig. 4 schematically illustrates a first example of long-term effect attention (and/or a traumatic task) for a time series having one channel of sensor data as input, and the physical parameter of the output being of the same type of sensor data as the input.

In the example of Fig. 4, each input consists of a series of colors (in particular corresponding to the sensor data received in the step S102), with one color being black. The positions of the black color and the other colors are selected uniformly at random. Each color is represented in RGB format, which consists of three integers ranging from 0 to 255. For example, black is represented as (0, 0, 0), while white is represented as (255, 255, 255). In the time series of the input data in Fig. 4, the sensor data 401-I; 402-I; 403-I; 404-I at the first four points in time correspond to a light shade of blue, yellow, pink and green, respectively. At the fifth point in time, the sensor data 405-1 correspond to the color black. The following sensor data 406-I; 407-I, 408-I; 409-I; 410-I; 411-I; 412-I; 413-I correspond to the same light shade of blue, blue, orange, pink, yellow, pink, green and green, respectively, as the light shade of the sensor data 401-1; 402-I; 403-I; 404-I before the color black 405-1 occurred.

In the example of Fig. 4, the output color (in particular corresponding to the physical parameter provided in the step S112) 401-0; 402-O; 403-O; 404-O of the first four points in time is identical to the input color (and/or sensor data) 401-1; 402-I; 403-I; 404-I. At the fifth point in time, the color black is output 405-O.

The objective of the example of Fig. 4 is to reproduce the exact color from the input before the black square appears, as exemplified by 401-1; 402-I; 403-I; 404-I and 401-O; 402-O; 403-O; 404-O. After the black square appears in in the input time series at reference sign 405-1 and in the output time series at reference sign 405-O, the task (also: goal) is to return the same color but in a darker shade. At reference signs 406-O; 407-O; 408-O; 409-O; 410-0; 411-0; 412-0; 413-0, after the black color 405-O, the colors blue, blue, orange, pink, yellow, pink, green and green, respectively, are provided as output in a darker shade than the corresponding input 406-I; 407-I, 408-I; 409-I; 410-I; 411-I; 412-I; 413-I. To achieve the darker shade, each of the three RGB coordinates may, e.g., be multiplied by 0.6 to create a darker version of the color.

In the example of Fig. 4, the "traumatic task" has the goal to minimize the Mean Squared Error (MSE) between the output data and the input data at a point in time, subject to the long-term effect of the modified shade of the color in the output time series after the color black occurred.

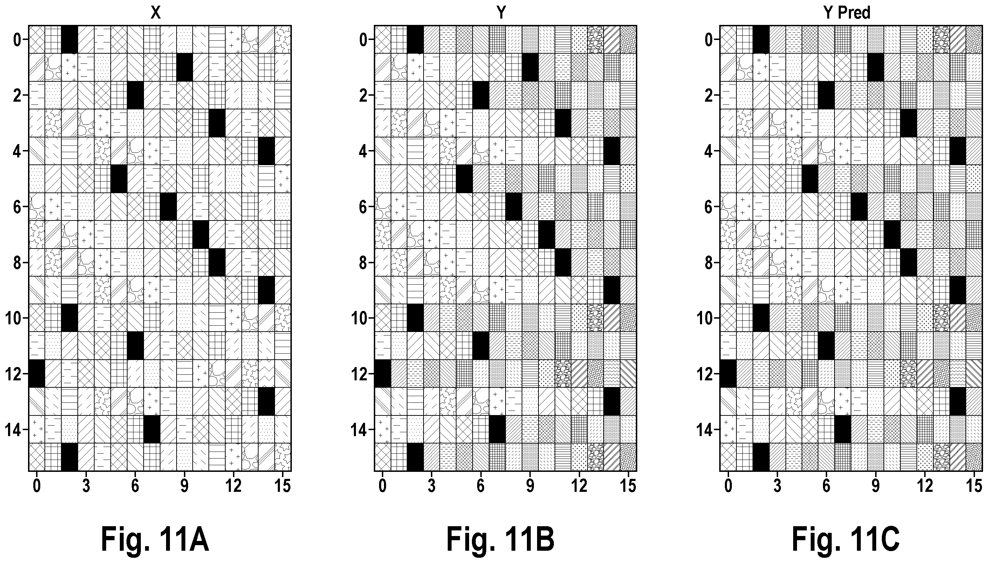

In Figs. 11A, 11B and 11C, further exemplary time series of the example of colors (or patterns) as input data (and/or sensor data) as well as output data (and/or physical parameter) with the color black as indicator of the predetermined long-term effect of changing from a lighter to a darker shade are provided.

In Fig. 11A, each row represents a new time series of input data. Fig. 11B shows the ground truth according to the general rule of converting each color after the black instance into a darker shade, and Fig. 11C shows the actual estimation output by a NN system, which agrees very well with the ground truth.

The example of Fig. 4 and Figs. 11A, 11B, 11C comprises a single channel in the time series of input data.

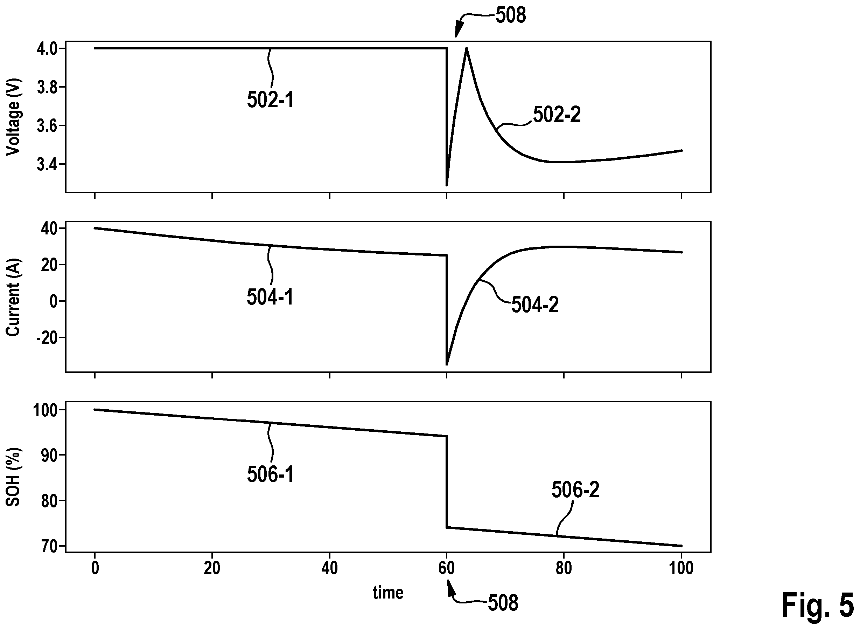

An example with two channels of the time series of input data (and/or sensor data) is illustrated in Fig. 5. In Fig. 5, a first channel of input data comprises voltage values (in Volt) and a second channel of input data comprises current values (in Ampere) of a rechargeable battery, with SoH value (as percentage) as output data (and/or physical parameter).

At reference signs 502-1; 504-1; 506-1, the voltage values, current values and SoH values, respectively, before a long-term effect occurs, are shown. At reference sign 508, a long-term effect occurs. The long-term effect 508 is visible as sudden drop in voltage, current and SoH. As illustrated at reference signs 502-2; 504-2, the voltage values and current values, respectively, recover at least partially after the instant 508, at which the long-term effect occurred. Despite the voltage 502-2 and the current 504-2 increasing again, the SoH value 506-2 after the long-term effect 508 occurred, is permanently lowered (and/or does not recover, not even partially).

The example of Fig. 5 makes use of a multivariate time series of sensor data. Multivariate time series (MTS) have, e.g., been used before for MTS forecasting with cross-dimension dependency between variables (such as the voltage values and current values in the example of Fig. 5 before the long-term effect occurred). A model architecture for an MTS forecasting and/or a time-series foundation model may, e.g., be based on the Crossformer model architecture in [1]. Alternatively or in addition, the NN system (such as the NN system 200) for performing the technique described herein may be based on a conventional MTS forecasting model, such as the Crossformer architecture, to which the routing of predetermined long-term effect data through the long-term effect memory is added.

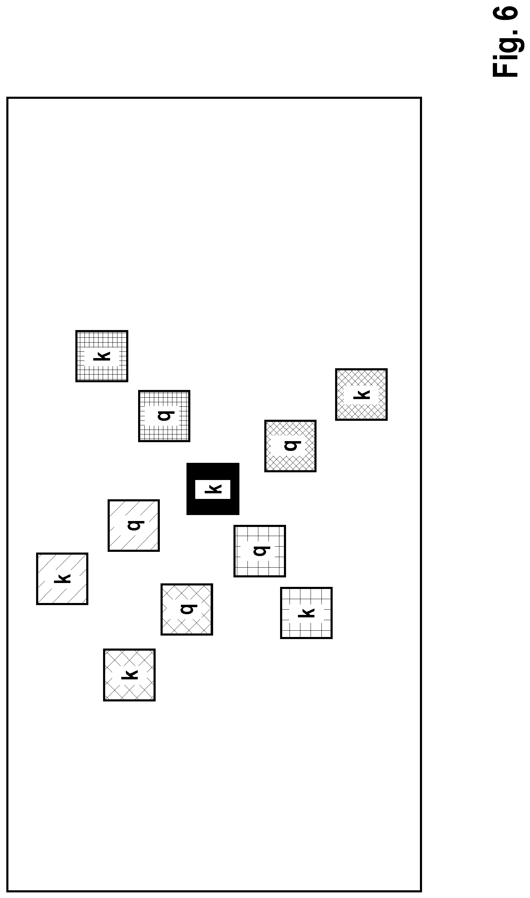

Fig. 6 schematically illustrates limitations of the conventional transformers, such as the crossformer, when applied to long-term effect data (and/or traumatic data).

The conventional attention mechanism for traumatic data presents an inherent difficulty. Understanding this difficulty is crucial for designing the new NN system architecture of the disclosed technique.

Using the color (or pattern) example of Figs. 4 and 11A-11C for illustrative purposes, the ideal attention should be high for each color's (or pattern's) key and the black color, as to decode its value, those are exactly the two quantities we need. In other words, the distribution that defines the attention weights, denoted as ${p}^{i} \left(j\right) = softmax \left({q}_{i}⋅{k}_{j}^{T}\right)$, should ensure that for each color *i,* both *pⁱ*(*i*) and *pⁱ*("black") are high.

In Fig. 6, this requirement is examined from a geometric perspective. When looking at all the keys and queries geometrically, it is observed that, for each non-black color,
(1) the query should be close to its key, i.e., high ${q}_{i} ⋅ {k}_{i}^{T}$, to receive high attention;
(2) the query should also be close to the black's key, i.e., high ${q}_{i} ⋅ {k}_{black}^{T}$; and
(3) the query should be far from all other keys to make sure that the last values are high after the *softmax*.

Unfortunately, it is not possible for all three requirements to be fulfilled simultaneously. If a non-black query is close to a black key and to its key, according to the triangle inequality, the non-black query is not too far from all non-black keys. This contradicts requirement (3).

From the above consideration, it can be concluded that there is a challenge in having many distinct queries that are close to the same key. This observation is crucial for the design of the new NN system architecture of the technique disclosed herein.

The new NN system architecture is designed to effectively process long-term effect data (and/or traumatic data). This is achieved through a two-step process: firstly, by incorporating a dedicated memory component (e.g., the long-term effect memory 208 of the NN system 200) that is always accessible to the attention mechanism (in particular comprising the inventive long-term effect attention), and secondly, by developing a method to learn the content of this memory.

In the first step, the long-term effect memory (also: traumatic memory) is incorporated into the attention mechanism.

To prevent divided attention, where numerous queries cannot simultaneously focus on the same key, a new long-term effect memory component is introduced. This long-term effect memory contains a subset of the data guaranteed to receive full attention since their occurrence. More formally, memory *M* ⊆ [*n*] is introduced, where n is the input length (and/or the length of the time series), that includes a subset of the input. The input in M is guaranteed to receive full attention at all times since they occurred. More precisely, Eq. (1) is modified to: ${r}_{i} = {\sum }_{j} {w}_{i , j} {v}_{j} + {\sum }_{j ∈ M ∧ j \leq i} {v}_{j}^{′} ,$ (2) where ${v}_{j}^{′} = f \left({x}_{j}\right)$ for some function *f.* The choice of M is discussed in the second step.

Several choices for the function f are possible:
(1) ${v}_{j}^{′} = {v}_{j}$: For this choice, the traumatic data has a similar value as the regular data. This option is not recommended as the two, regular and traumatic data, should have different meaning.
(2) ${v}_{j}^{′} : = {x}_{j} {W}^{V ′}$: This approach employs a projection for the traumatic data, like the use of projection in standard attention, but with a distinct projection matrix W^{V'} replacing the conventional matrix W^{V} of the conventional determination of the value. This choice is recommended for its simplicity (e.g., retaining the use of a projection) while providing greater flexibility compared to using the same projection.

The value function ${v}_{j}^{′}$ for the traumatic data need not be the exact same value function as in the regular case. Alternatively or in addition, the distinct attention weights, and/or the distinct projection matrix *W*^{*V*'}, may be learned during the training of the NN system, e.g., similarly to the conventional matrix W^{V}.

Use a nonlinear function, such as a small neural network.

In the second step, the content of the traumatic memory, *M,* is learned using a variation (and/or generalization) of the mixture-of-depth technique.

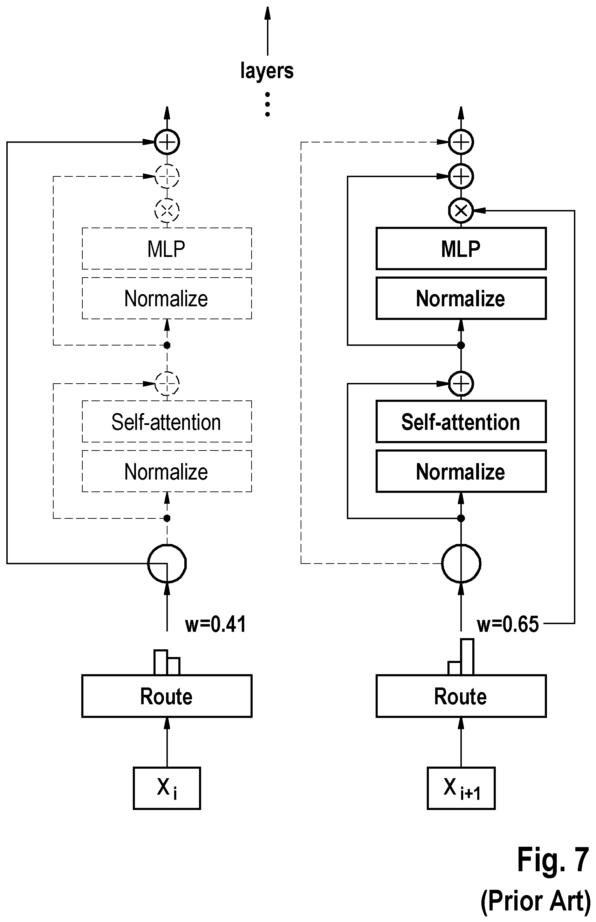

The concept of mixture-of-depth (MoD) [3] is, according to the disclosed technique, modified and adopted in a novel way to facilitate learning the content of long-term effect memory (also: traumatic memory). The MoD technique it is conventionally used to reduce computational requirements. Originally, the MoD technique was proposed to mitigate the quadratic complexity of the attention mechanism. Rather than requiring all inputs to pass through the attention mechanism as schematically indicated on the right-hand side of Fig. 7, which is reproduced from Fig. 1 of [3], it restricts the inputs processed by the mechanism to a subset of size k, where k is smaller than the total input size. The remaining inputs bypass the attention mechanism entirely, as schematically indicated on the left-hand side of Fig. 7.

More formally, the MoD method introduces a router w that generates a ranking *r̂ᵢ* of all inputs by computing the following: ${\hat{r}}_{i} = {w}^{T} {x}_{i} .$ (3)

The top-k elements according to this ranking are calculated *P* = {*xᵢ*: *xᵢ is one of the top k elemets according to r*}. An attention mechanism h is then applied, as illustrated in Fig. 7. Specifically, the result for the i-th element according to the MoD technique is given by: $\left\{\begin{matrix}{\hat{r}}_{i} h \left(P\right) + {x}_{i} & if i ∈ P \\ {x}_{i} & otherwise\end{matrix}\right. .$

The long-term effect memory of the inventive technique disclosed herein is learned in several steps. The highest element, following the router, is utilized as the content for the long-term effect memory. Specifically, in a first step, the functionality of the router is determined (and/or calculated). Eq. (3) from the conventional MoD technique is adjusted for the technique disclosed herein to: ${\hat{r}}_{i} = {w}^{T} g \left({x}_{i}\right) .$ (4)

Several choices for g are possible:
(1) g can be the identity function, which brings Eq. (4) back to Eq. (3).
(25) Use a nonlinear function, such as a small neural network. The inventors found that this choice showed superior results.

In a second step, the top-k values, P, are inserted into the long-term effect memory M.

In a third step, the inventive long-term effect attention mechanism is performed using the long-term effect memory M. This operation is denoted by C in Eq. (5) below. Using a modification of ideas of the MoD technique, one can calculate:${\hat{r}}_{i} C \left(x\right)$ (5).

Analogously to the MoD technique, to effectively learn the parameters of the router, it is beneficial to facilitate the gradient flow. Empirical observations suggest that multiplying by the router weights *r̂ᵢ*, as shown in Eq. (5), aids in this process. For the present disclosure, the computation C(x) involves the long-term effect attention mechanism.

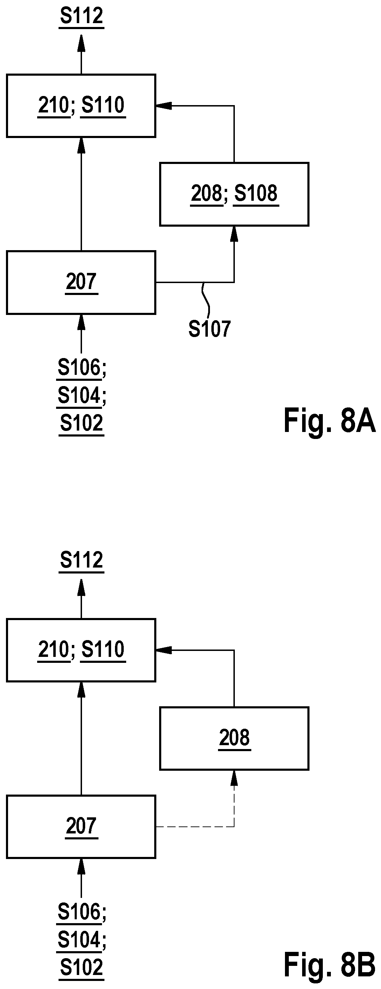

The long-term effect attention (and/or new paradigm) is schematically demonstrated in Figs. 8A and 8B, with Fig. 8A representing inputs (and/or sensor data indicative of a long-term effect) entering the long-term effect memory and Fig. 8B representing all other inputs (and/or sensor data not indicative of a long-term effect).

Within the disclosed technique, a new parameter, the long-term effect memory size, is introduced. In experiments, the long-term effect memory size was set to 1 (e.g., for one instant of sensor data). However, the memory size is a hyperparameter that can be tuned using a validation set. Said differently, the long-term effect memory size may be bigger than 1. This may be favorable if multiple different long-term effects are known for a specific combination of sensor data and resulting estimated physical parameter.

Exemplary pseudocode for implementing the technique disclosed herein reads as follows:
Step 1: Learning the memory
   - Calculate result of the router x_trauma using Eq. (4);
   - Values, traumatic_memory := topk(x_trauma);
   - Calculate the result of the computation using Eq. (5).
Step 2: Calculate regular attention (also: conventional attention)
   - Compute keys, queries, and values and attention weights according to Eq. (1).
Step 3: New long-term effect Memory added to regular attention
   - Add to the above term the value of the elements calculated in step 1, i.e., Eq. (2).

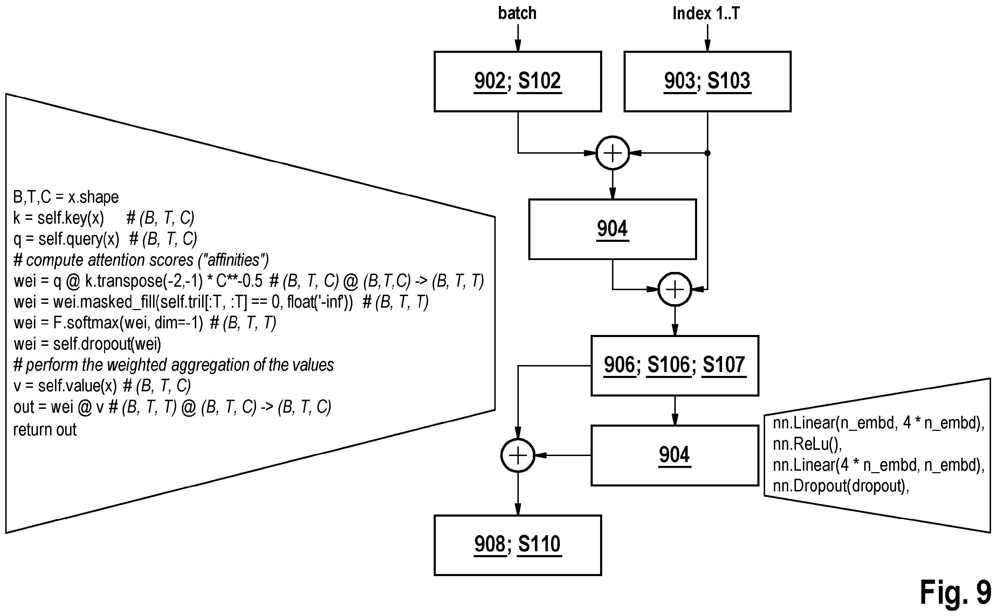

Fig. 9 further exemplifies pseudocode as well as NN system architecture components for performing the disclosed technique. At reference sign 902, linear token embedding is indicated for the received time series of sensor data (e.g., the voltage and current for estimating the SoH of a rechargeable battery; or the input colors of Fig. 4). At reference sign 903, positional encoding (e.g., according to a learned table) is indicated. The positional encoding may refer to points in time (also: time steps) of the sensor data. The sensor data at any particular point in time may be denoted as instantaneous sensor data. The sensor data, which are indicative of the predetermined long-term effect, may be a subset of the instantaneous sensor data, namely associated with the one (or a few) point(s) in time, at which the long-term effect occurred.

At reference sign 904 in Fig. 9, FeedForward layers are indicated. At reference sign 906, a head (e.g., comprising the first set of hidden layers 206, which may determine weights of the conventional attention mechanism, the router 207, and/or MLP layers) is indicated. At reference sign 908, a linear projection layer is indicated. The linear projection layer may be representative of the second set of hidden layers 210, which perform the estimating of the at least one physical parameter per point in time (e.g., the SoH for the rechargeable battery).

An empirical comparison was performed for the color example of Fig. 4. Both the conventional attention mechanism and the technique disclosed herein with the inventive long-term effect attention where texted using the following parameters: Batch size = 16; Sequence length= 32; Max iterations = 100000; learning_rate = 1e-3; n_embd = 4; n_head = 1; n_layer = 1; and n_examples = 2048.

A scheme of the entire test process is illustrated by Fig. 9. The Head 906 can be regarded as corresponding to the attention diagram in Figs. 8A and 8B spanning the block from reference signs 207, 208 to 210.

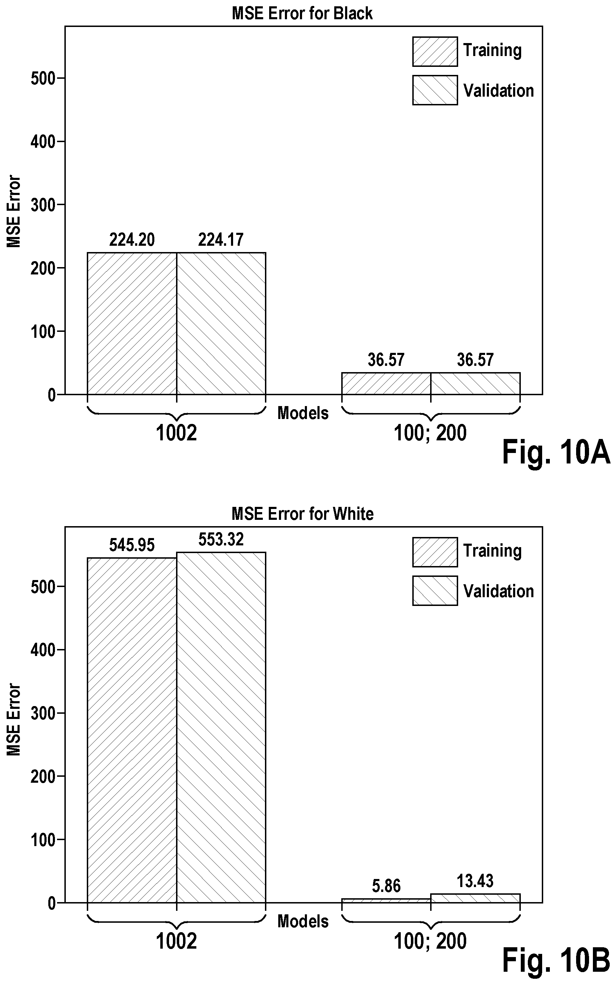

The results of the exemplary empirical comparison are shown in Figs. 10A and 10B. The y-axis in each case represents the MSE error, and the x-axis corresponds to the model's performance on both training and validation datasets. At reference sign 100; 200, the inventive technique (e.g., according to the illustration of Fig. 9) is indicated. At reference sign 1002, the conventional attention mechanism only was used.

In Fig. 10A, the MSE error was determined for black as long-term effect (also: traumatic event), as described in connection with Fig. 4. In Fig. 10B, the results depict the scenario where the traumatic event is represented as a white square (RGB: 255, 255, 255) instead of a black square (RGB: 0, 0, 0). From Figs. 10A and 10B, it is evident that training and validation performance are comparable for each model. Notably, there is a more than five (5)-fold improvement in MSE when the traumatic event is represented as a black square and an impressive hundred (100)-fold improvement when the traumatic is represented as a white square.

Fig. 11A schematically illustrates a plurality of time series of colors (or patterns) as inputs according to the scheme explained in connection with Fig. 4. Fig. 11B illustrates the corresponding ground truth as outputs. In Fig. 11C, estimations output by the (in particular trained) NN system (e.g., the NN system 200, in particular using the architecture of Fig. 9) using the inventive long-term effect attention are illustrated. As visible, the output estimation of Fig. 11C and the ground truth in Fig. 11B show excellent agreement.

The technique disclosed herein can be applied to the development and training of Time-Series-Foundation-Models and pre-trained time-series models.

### Cited Prior Art, incorporated herein by reference

[1] Yunhao Zhang & Junchi Yan, CROSSFORMER: TRANSFORMER UTILIZING CROSSDIMENSION DEPENDENCY FOR MULTIVARIATE TIME SERIES FORECASTING, ICLR 2023
[2] Ashish Vaswani et al., Attention Is All You Need, 31st Conference on Neural Information Processing Systems (NIPS 2017), Long Beach, CA, USA, arXiv:1706.03762v7 [cs.CL] 2 Aug 2023
[3] David Raposo et al., Mixture-of-Depths: Dynamically allocating compute in transformer-based language models, 2024 Google DeepMind, arXiv:2404.02258v1 [cs.LG] 2 Apr 2024

## Claims

1. Computer-implemented method (100) for providing, by a neural network, NN, system, an estimated time series of a physical parameter based on a time series of sensor data indicative of a long-term effect, comprising the method steps of:
- Receiving (S102) input data comprising a time series in at least a first channel of sensor data;
- Determining (S106), for each point in time within the time series, if instantaneous sensor data associated with the point in time are indicative of a predetermined long-term effect;
- Selectively storing (S108) the instantaneous sensor data, for which an indication of the predetermined long-term effect was determined (S106);
- Estimating (S110) a time series of at least one physical parameter based on the received (S102) input data, wherein the estimating (S110) comprises applying long-term effect attention to the selectively stored (S108) instantaneous sensor data for all points in time after the point in time, for which the instantaneous sensor data were selectively stored (S106); and
- Providing (S112) the estimated (S110) time series as output data.

2. The method (100) of claim 1, wherein a channel, in particular the first channel, of sensor data comprises sensor data indicative of a voltage, a current, a power, a resistance, a capacity, a temperature, a humidity, a gas concentration, a pressure, a velocity, a force, a torque, a rotational speed, a color, and/or a luminosity.

3. The method (100) according to any one of the preceding claims, further comprising the step of:
- Routing (S107) the instantaneous sensor data, for which the indication of the predetermined long-term effect was determined (S104), to a long-term effect memory.

4. The method (100) according to any one of the preceding claims, wherein the NN system comprises an encoder and a decoder, and/or wherein the NN system comprises a transformer architecture, a recurrent neural network, RNN, architecture, and/or a convolutional neural network, CNN, architecture.

5. The method (100) according to any one of the preceding claims, wherein the time series comprised in the received (S102) input data comprises a second channel of sensor data, optionally wherein the first channel comprises sensor data indicative of a voltage of a rechargeable battery, and wherein the second channel comprises sensor data indicative of a current of the rechargeable battery.

6. The method (100) according to any one of the preceding claims, wherein the sensor data are indicative of a physical state of a physical object, and wherein the time series of the at least one physical parameter encodes the physical state of the physical object.

7. The method (100) according to any one of the preceding claims, wherein the at least one physical parameter comprises a state of health, SoH, of a rechargeable battery.

8. The method (100) according to any one of the preceding claims, further comprising the step of:
- Preprocessing (S103) the received (S102) input data, wherein preprocessing (S103) comprises providing a positional encoding for each of the instantaneous sensor data.

9. The method (100) according to any one of the preceding claims, further comprising the step of:
- Determining (S104), for each point in time within the time series, attention weights associated with the instantaneous sensor data;
wherein determining (S106) if the instantaneous sensor data are indicative of a predetermined long-term effect comprises determining that the associated attention weight exceeds a predetermined threshold value; and
wherein estimating (S110) the time series of at least one physical parameter further comprises applying the determined (S104) attention weights to all instantaneous sensor data, in particular including the instantaneous sensor data indicative of a predetermined long-term effect.

10. The method (100) according to any one of the preceding claims, wherein applying long-term effect attention comprises:
- Applying a predetermined projection matrix on a linear function of the instantaneous sensor data indicative of a predetermined long-term effect; or
- Applying a non-linear function on the instantaneous sensor data indicative of a predetermined long-term effect.

11. The method (100) according to any one of the preceding claims, wherein the NN system is trained by means of supervised learning on a database of training datasets comprising a time series in at least a first channel of sensor data and a time series of at least one physical parameter as ground truth.

12. The method (100) according to any one of the preceding claims, wherein the instantaneous sensor data, for which an indication of the predetermined long-term effect was determined (S106), are selectively stored (S108) in a long-term effect memory, and wherein a size of the long-term effect memory is parameterized by tunable hyperparameter.

13. A neural network, NN, system (200) for providing an estimated time series of a physical parameter based on a time series of sensor data indicative of a long-term effect, comprising:
- An input layer (202), which is configured for receiving input data comprising a time series in at least a first channel of sensor data;
- A first set of hidden layers (206), which is configured for determining, for each point in time within the time series, if instantaneous sensor data associated with the point in time are indicative of a predetermined long-term effect;
- A long-term effect memory (208), which is configured for selectively storing the instantaneous sensor data, for which an indication of the predetermined long-term effect was determined;
- A second set of hidden layers (210), which is configured for estimating a time series of at least one physical parameter based on the received input data, wherein the estimating comprises applying long-term effect attention to the selectively stored instantaneous sensor data for all points in time after the point in time, for which the instantaneous sensor data were selectively stored; and
- An output layer (212), which is configured for providing the estimated time series as output data.

14. The NN system (200) of claim 13, further comprising any one of the features, or being configured to perform any one of the steps, of claims 2 to 12.

15. A computer program product comprising program elements which induce a computing device to carry out the steps of the method for providing an estimated time series of a physical parameter based on a time series of sensor data indicative of a long-term effect according to one of the preceding method claims, when the program elements are loaded into a memory of the computing device.
